# EUROPEAN PATENT APPLICATION

(11) **EP 4 561 045 A1**
(43) Date of publication of application: **28.05.2025**
(21) Application number: 22941861.1
(22) Date of filing: 21.07.2022

(54) **PHOTOGRAPHIC APPARATUS AND CONTROL METHOD**

(71) Applicant: Beijing Xiaomi Mobile Software Co., Ltd., Beijing 100085 (CN)
(72) Inventor: YAMASHITA, Yuichiro, Tokyo 141-0031 (JP); KOBAYASHI, Atsushi, Tokyo 141-0031 (JP)
(74) Representative: dompatent von Kreisler Selting Werner - Partnerschaft von Patent- und Rechtsanwälten mbB
(86) International application number: PCT/CN2022/107202
(87) International publication number: WO 2024/016288

(57) **Abstract**

A photographing device (100) includes: a plurality of microlenses (7); a photographing element having a plurality of pixels arranged on each of the plurality of microlenses (7) and configured to receive light from the plurality of microlenses (7); and an image generation unit (36) configured to generate an image based on the light received at the plurality of pixels (2). The plurality of pixels (2) each have a first part including a central part and a second part surrounding the central part. The image generation unit (36) judges whether to synthesize a first image based on the light received at the first part with a second image based on the light received at the second part based on a specified condition. Therefore, it can be judged whether to synthesize a plurality of images based on the light received at different parts of the pixel in one photographing.

## Description

### FIELD

The present disclosure relates to a photographing device and a control method.

### BACKGROUND

In the past, in cameras, digital cameras and the like with built-in solid-state photographing elements, in order to adjust a light amount of an object to be photographed imaged on the solid-state photographing elements or films, a mechanical aperture mechanism for controlling an aperture diameter is provided. For example, patent document 1 discloses an aperture mechanism in which the aperture diameter is controlled by rotating a plurality of blades in the same direction through a driving ring rotated by a stepping motor.

### Prior art document

### Patent document

Patent document 1: Patent No. 4618860.

### SUMMARY

### Problem to be solved by invention

However, in the photographing device with the mechanical aperture mechanism described in patent document 1, it is inherently impossible to generate a plurality of images with different apertures in one photographing. Therefore, it will not be envisaged to judge whether to synthesize images with different apertures in one photographing.

Therefore, an object of the present disclosure is to provide a photographing technique which can judge whether to synthesize a plurality of images based on light received at different parts of a pixel in one photographing.

### Solution to problem

A photographing device according to an aspect of the present disclosure includes: a plurality of microlenses; a photographing element having a plurality of pixels arranged on each of the plurality of microlenses and configured to receive light from the plurality of microlenses; and an image generation unit configured to generate an image based on the light received at the plurality of pixels. The plurality of pixels each have a first part including a central part and a second part surrounding the central part. The image generation unit is configured to judge whether to synthesize a first image based on the light received at the first part with a second image based on the light received at the second part based on a specified condition.

A control method of an aspect of the present disclosure is executed by a processor included in a photographing device, and includes a step of generating an image based on light received by a plurality of pixels arranged on each of a plurality of microlenses included in the photographing device and from the plurality of microlenses. The plurality of pixels each have a first part including a central part and a second part surrounding the central part, and the step of generating judges whether to synthesize a first image based on the light received at the first part with a second image based on the light received at the second part based on a specified condition.

### Effect of invention

According to the present disclosure, it can be judged whether to synthesize a plurality of images based on light received at different parts of a pixel in one photographing.

### BRIEF DESCRIPTION OF THE DRAWINGS

Fig. 1 is a diagram illustrating an example of a configuration of a photographing device according to an embodiment of the present disclosure.
Fig. 2 is a diagram illustrating a light reception situation in a primary lens according to an embodiment of the present disclosure as viewed in direction II in Fig. 1.
Fig. 3 is a diagram illustrating a light reception situation in a pixel according to an embodiment of the present disclosure as viewed in direction III in Fig. 1.
Fig. 4 is a diagram illustrating an example of a configuration of an image sensor according to an embodiment of the present disclosure.
Fig. 5 is a diagram illustrating an example of a functional configuration of a control unit according to an embodiment of the present disclosure.
Fig. 6 is a flow chart illustrating an example of an image generation processing according to an embodiment of the present disclosure.
Fig. 7 is a diagram illustrating an example of a processing of electronically adjusting a background bokeh according to an embodiment of the present disclosure.
Fig. 8 is a diagram illustrating an example of a light traveling situation due to fluctuation of light according to an embodiment of the present disclosure.
Fig. 9 is a diagram illustrating an example of a case where an optical path length from a light exit surface of a microlens to a light incident surface of a first part of a pixel is different from an optical path length from the exit surface to a light incident surface of a second part of the pixel according to an embodiment of the present disclosure.
Fig. 10 is a diagram illustrating another example of a case where an optical path length from a light exit surface of a microlens to a light incident surface of a first part of a pixel is different from an optical path length from the exit surface to a light incident surface of a second part of the pixel according to an embodiment of the present disclosure.
Fig. 11(A) is a diagram illustrating an example of a configuration of a sub-pixel according to an embodiment of the present disclosure.
Fig. 11(B) is a diagram illustrating another example of a configuration of a sub-pixel according to an embodiment of the present disclosure.

### DETAILED DESCRIPTION

Hereinafter, preferred embodiments of the present disclosure will be described in detail with reference to the accompanying drawings. In addition, the embodiments described below are always specific examples for implementing the present disclosure, and are not intended to explain the present disclosure in a limited manner. In addition, in order to facilitate the understanding and explanation, the same components are sometimes labeled with the same reference signs as much as possible in the drawings, and repeated explanations are omitted.

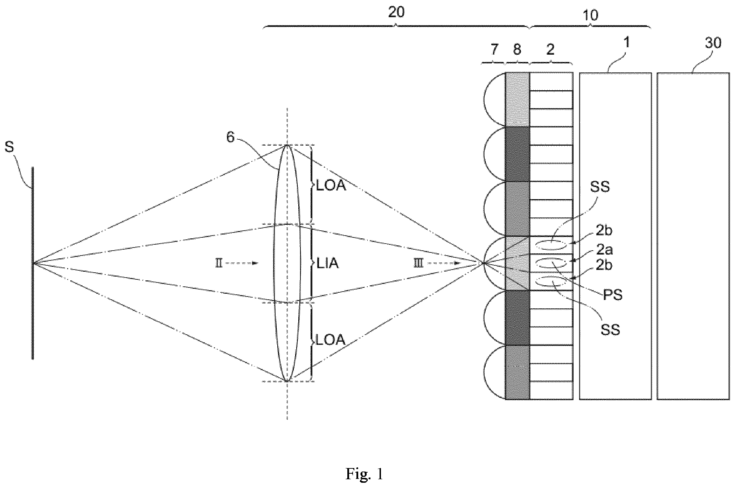

Fig. 1 is a diagram illustrating an example of a configuration of a photographing device according to an embodiment of the present disclosure. For example, a photographing device 100 includes an image sensor 10 (a photographing element), an optical system 20, and a control unit 30.

The image sensor 10 is a device that receives light emitted from an object S to be photographed and converts a brightness of the light into electrical information. For example, the image sensor 10 at least includes a pixel group composed of a plurality of pixels 2 and a control circuit 1. The control circuit 1 controls and drives the pixel group, reads out data based on optical signals accumulated in the pixel group, and outputs the data to the outside of the image sensor 10.

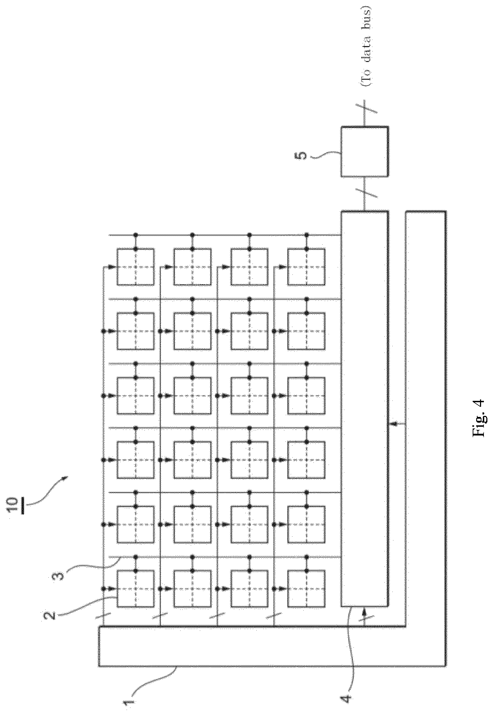

The plurality of pixels 2 in the pixel group are arranged on each of a plurality of microlenses 7 described later, and receive light from the plurality of microlenses 7. A specific configuration of the image sensor 10 will be described with reference to Fig. 4. In addition, as described above, the image sensor 10 may have a pixel group, and the optical system 20 may also have a pixel group.

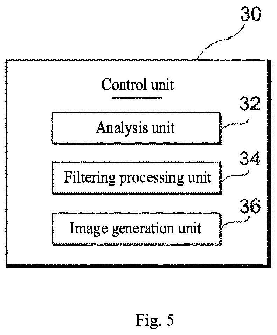

The control unit 30 generates an image by analyzing data based on the data output from the image sensor 10. A specific configuration of the control unit 30 will be described with reference to Fig. 5.

The optical system 20 includes one or more devices for condensing the light emitted from the object S to be photographed. The optical system 20 includes, for example, a primary lens 6, a microlens 7, and a color filter 8.

The primary lens 6 has a function as a photographic lens, for example. The primary lens 6 has a central region LIA and a peripheral region LOA. The setting method of the central region LIA and the peripheral region LOA in the primary lens 6 is arbitrary, and the central region LIA and the peripheral region LOA in the primary lens 6 may be appropriately set based on the property and configuration of each component of the photographing device 100.

The micro-lens 7 is, for example, a condensing lens. One or more microlenses 7 are arranged on top of or in front of the pixel group 2, and the plurality of pixels included in the pixel group 2 have the function of converging desired light, respectively. Each microlens 7 corresponds to a pixel of the color filter 8 described later (for example, each of the plurality of pixels included in the pixel group 2).

The color filter 8 corresponds to, for example, any one color of red, green, and blue as primary colors. The color filter 8 may be a color filter of complementary colors (for example, yellow, light blue and magenta), which may be adapted appropriately according to the application. The color filter 8 is of, for example, an on-chip type, but is not limited to this, and may be of an adhesive type or other forms. In addition, the color filter 8 may have a different configuration from the microlens 7, or may be a part of the microlens 7.

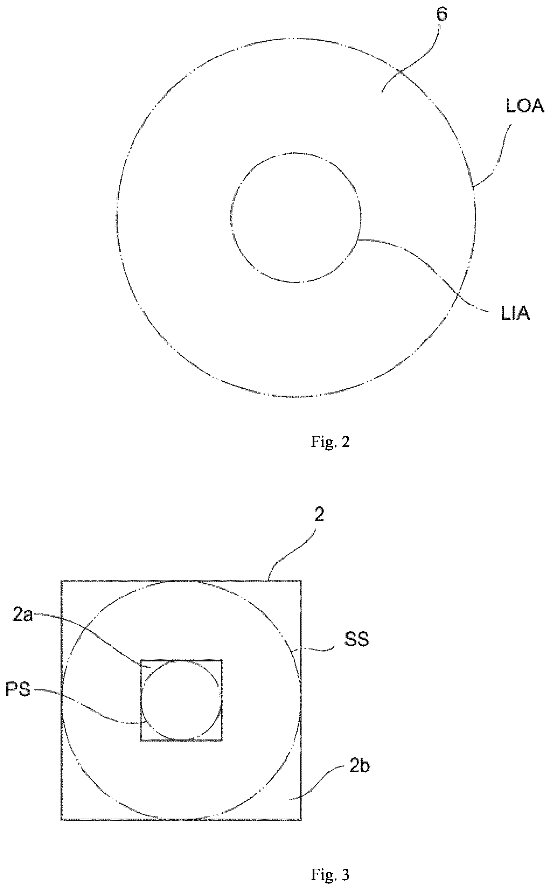

Fig. 2 is a diagram illustrating a light reception situation in the primary lens 6 according to the embodiment of the present disclosure as viewed in a direction II in Fig. 1. As shown in Fig. 1 and Fig. 2, in the photographing device 100, the light emitted from the object S to be photographed passes through, for example, the central region LIA and the peripheral region LOA of the primary lens 6, respectively, and is incident on the microlens 7.

Fig. 3 is a diagram explaining a light reception situation in a pixel according to the embodiment of the present disclosure as viewed in a direction III in Fig. 1. As shown in Figs. 1 and 3, for example, each of the plurality of pixels 2 has a central sub-pixel 2a (a first part) including a central part; and a peripheral sub-pixel 2b (a second part) surrounding the central part. The central sub-pixel 2a receives an optical signal (a primary signal PS) of the light passing through the central region LIA of the primary lens 6. The peripheral sub-pixel 2b receives an optical signal (a secondary signal SS) of the light passing through the peripheral region LOA of the primary lens 6.

Fig. 4 is a diagram illustrating an example of a configuration of the image sensor according to the embodiment of the present disclosure. The image sensor 10 is, for example, a CMOS image sensor. The image sensor 10 includes, for example, the control circuit 1 shown in Fig. 1, the pixel group of the plurality of pixels 2 arranged in two dimensions, a signal line 3, a readout circuit 4, and a digital signal processing unit (DSP) 5.

The configuration of the plurality of pixels 2 is arbitrary. For example, the plurality of pixels 2 may be grouped by collecting a plurality of individual pixels, thus forming one pixel group (unit pixel group). In addition, as shown in Fig. 4, the plurality of pixels 2 may, for example, group 4 (2x2) pixels to form one pixel group. Moreover, for example, 3 (3×1) pixels, 8 (4×2) pixels, 9 (3×3) pixels, and 16 (4×4) pixels may serve as the unit pixel group of the plurality of pixels 2.

The plurality of pixels 2 are arranged in the two dimensions, the optical signal brought to the image sensor 10 is accumulated based on a control signal from the control circuit 1 and control signals generated by the plurality of pixels 2 themselves, and data (an electric signal) based on the optical signal is read out.

The electrical signal read out from the plurality of pixels 2 is transmitted to the readout circuit 4 through the signal line 3 (typically, a column signal line parallel to a column direction), and the electrical signal is analog-to-digital converted.

The digital signal processing unit (DSP) 5 processes a digital signal after being analog-to-digital converted by the readout circuit 4. Moreover, the processed digital signal is transmitted to a processor, a memory or the like of the photographing device through a data bus.

In addition, the DSP5 is not limited to this configuration. For example, the image sensor 10 may not include the DSP5, and the subsequent processor (for example, the control unit 30) may have the DSP. In addition, there may also be a following configuration, in which the DSP5 of the image sensor 10 and the DSP included in the subsequent processor or the like may handle a part of digital signal processing in image processing. In other words, the position of the DSP in the present disclosure is not limited to a specified position.

Fig. 5 is a diagram illustrating an example of a functional configuration of the control unit according to the embodiment of the present disclosure. As shown in Fig. 5, the control unit 30 (for example, the processor) functionally includes an analysis unit 32, a filtering processing unit 34, and an image generation unit 36. In addition, the above units of the control unit 30 may be realized by, for example, using a storage region such as a memory and a hard disk provided in the photographing device 100, or the processor to execute a program stored in the storage region.

The analysis unit 32 analyzes the data based on the data output from the image sensor 10. For example, the analysis unit 32 analyzes the primary signal PS or a first image (for example, a primary image generated based on the primary signal PS) and acquires information about the depth of field and sensitivity to light. The analysis unit 32 analyzes the secondary signal SS or a second image (for example, a secondary image generated based on the secondary signal SS), and acquires information such as whether the secondary signal SS contains a flare component and whether the secondary signal SS loses sharpness.

For example, when one or more images are generated, the analysis unit 32 may also acquire and analyze the position information of each image and the position information of the pixel corresponding to each image. The analysis unit 32 may also calculate a correlation of a plurality of images and specify a part with a high correlation (e.g., an in-focus part) or a part with a small correlation (e.g., an out-of-focus part).

The filtering processing unit 34 performs a filtering processing on the generated image based on an analysis result of the analysis unit 32. For example, the filtering processing unit 34 may also perform a specified spatial filtering processing on the second image generated based on the position information of the image acquired by the analysis unit 32.

The filtering processing unit 34 may also perform a specified low-pass filtering processing on the part with the small correlation based on the correlation of the plurality of images analyzed by the analysis unit 32.

The image generation unit 36 may generate one or more images based on the light received at the plurality of pixels 2. For example, based on a specified condition, the image generation unit 36 judges whether to synthesize the primary image (the first image) based on the light (the primary signal PS) received at the central sub-pixel 2a shown in Figs. 1 and 3 with the secondary image (the second image) based on the light (the secondary signal SS) received at the peripheral sub-pixel 2b. In addition, as described above, the "second image" includes the secondary image generated based on only the secondary signal SS, but is not limited to this, and may also include the secondary image generated based on the primary signal PS and the secondary signal SS.

Here, the "specified condition" includes a condition related to the primary image (the first image), but is not limited to this. For example, when judging the synthesis of the plurality of images, as the "specified condition," a condition related to the secondary image (the second image) may replace the condition related to the primary image or be further additionally referred to. Furthermore, as the "specified condition," it is also possible to preset whether the photographing device 100 synthesizes the primary image (the first image) and the secondary image (the second image) or not. In addition, the "specified condition" may be fixed or appropriately changed based on the user's usage situation.

Here, the primary signal PS (the primary image) and the secondary signal SS (the secondary image), as well as the usage modes of the primary signal PS and the secondary signal SS in this embodiment are classified as followings (1) to (3).

### < (1) a case where the secondary signal SS (the secondary image) is not needed >

With regard to this usage mode (1), the image generation unit 36 generates the primary image based on only the primary signal PS, and takes the generated primary image as a final image. It is assumed that at least one of the depth of field and the sensitivity to light is analyzed for the primary signal PS by the analysis unit 32. For example, it is assumed that at least one of the depth above a specified threshold and the sensitivity below a specified threshold is detected. The specified threshold related to the depth of field and the specified threshold related to the sensitivity are arbitrary values, which may be fixed values or values that may be appropriately changed according to the design of the photographing device 100.

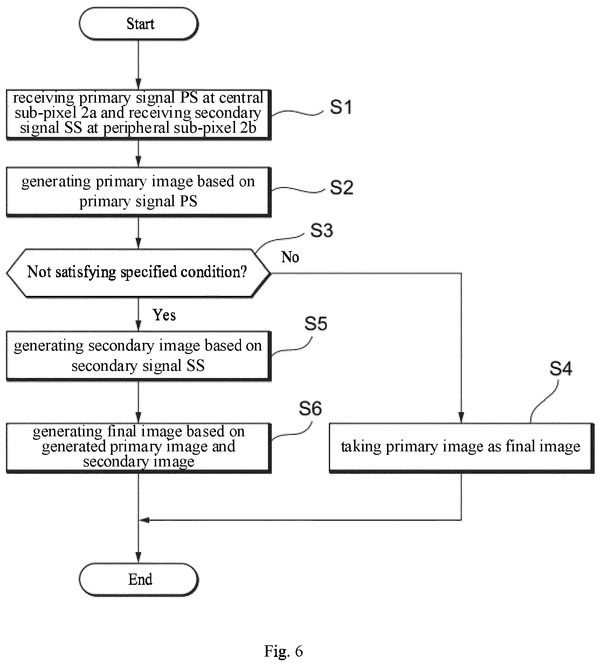

Here, the specified condition related to the primary image (the first image) includes, for example, at least one of whether the depth of field of the primary signal PS (the primary image) is above the specified threshold and whether the sensitivity to light of the primary signal PS (the primary image) is below the specified threshold. For example, when the depth of field of a certain primary signal PS (primary image) is above the specified threshold, this condition is satisfied, so that only the primary image based on the primary signal PS is used, while the secondary image based on the secondary signal SS is not used (refer to steps S3 and S4 in Fig. 6 described later).

In the usage mode (1), the photographing device 100 may perform photographing with a high depth of field and a low sensitivity to light by using only the primary signal PS (the primary image). In addition, the photographing device 100 may perform so-called electronic aperture processing without the need for a conventional mechanical aperture mechanism.

### < (2) a case where the secondary signal SS is used and the secondary signal SS contains, for example, optically unpreferred deterioration >

In the case of the above usage mode (1), when the depth of field increases, the optical signal used in the final image will decrease, so it is necessary to weigh the deterioration of the signal-to-noise ratio. Especially when the brightness of the object to be photographed is low, the adverse effects of the weighing become significant, so it is expected to eliminate/reduce the adverse effects of the weighing by using the secondary signal SS as described later, and also to improve the image quality of the final image. In addition, the improvement of the image quality includes, for example, improving at least one of the depth of field, SNR, MTF, and color reproducibility.

For example, the usage mode (2) may also include the following subcategories (i), (ii) and (iii). In the usage mode (2), the image generation unit 34 synthesizes the primary image and the secondary image based on information related to the secondary image (for example, a flare component of the secondary signal SS or a component related to non-ideal optical characteristics of the primary lens 6 and the like).

### < < (i) a case where the secondary signal SS contains the flare component > >

When the secondary signal SS contains the flare component due to undesired reflection or the like inside an optical system of a camera, the analysis unit 32 detects the flare component. The image generation unit 34 reconstructs the secondary image based on the analysis result of the flare component. The image generation unit 34 generates the final image by adding the reconstructed secondary image to the primary image, so that the image quality of the final image may be improved.

### < < (ii) a case where the secondary signal SS has a loss of sharpness > >

When the secondary signal SS contains the component (such as the loss of sharpness) related to the non-ideal optical characteristics (such as manufacturing limitations and manufacturing deviations) of the primary lens 6 shown in Fig. 1, the analysis unit 32 detects the component. The image generation unit 34 reconstructs the secondary image based on the analysis result of the component related to the non-ideal optical characteristics. The image generation unit 34 generates the final image by adding the reconstructed secondary image to the primary image, so that the image quality of the final image may be improved.

### < < (iii) increasing depth of field by reducing weighing of SNR decline > >

Under the photographic condition that the SNR decline of the primary signal PS is concerned, the SNR may be recovered by adding the secondary signal SS to the primary signal PS after performing a sharpness processing on the secondary signal SS. In addition, for example, the sharpness processing may include unsharp masking, deconvolution processing, optimization processing with the primary signal PS and an out-of-focus amount as reference information, and processing through neural networks.

The method of image reconstruction is arbitrary. For example, the image reconstruction method includes the following method: modeling the optical characteristics, and using an analytical inverse function or using an inverse function as a table lookup preparation. The image reconstruction method may also include the following method: modeling the optical characteristics, separately calculating a Point Spread Function (PSF), and performing the deconvolution processing. The image reconstruction method may also include the following method: after simplifying the physical and optical characteristics to a certain extent, modeling the physical and optical characteristics to perform regularization, normalization or optimization, or using AI technology (for example, Deep Learning) to generate the final image.

### < (3) a case where at least one of the primary signal PS and the secondary signal SS is used as additional information to change the primary signal PS and the secondary signal SS >

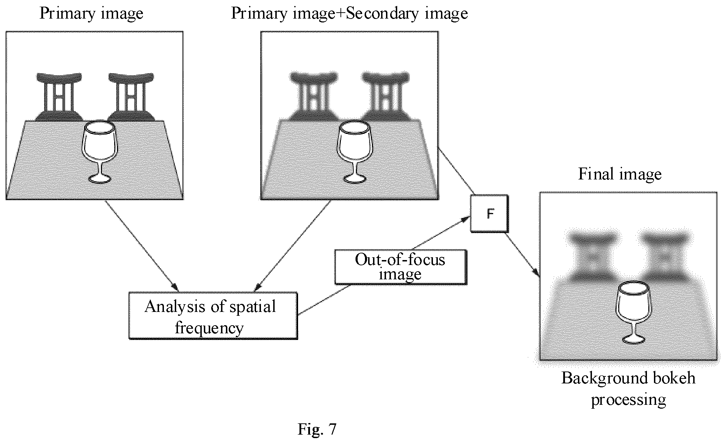

For example, the usage mode (3) includes a method of controlling a background bokeh of an image as described with reference to Fig. 7.

According to this embodiment, the photographing device 100 includes: the plurality of microlenses 7; the photographing element having the plurality of pixels 2 arranged on each of the plurality of microlenses 7 and configured to receive the light from the plurality of microlenses 7; and the image generation unit 36 configured to generate the image based on the light received at the plurality of pixels 2. In the photographing device 100, the plurality of pixels 2 each have the central sub-pixel 2a including the central part and the peripheral sub-pixel 2b surrounding the central part. In the photographing device 100, the image generation unit 36 judges whether to synthesize the primary image with the secondary image based on the light received at the peripheral sub-pixel 2b or not, based on the specified condition related to the primary image based on the light received at the central sub-pixel 2a.

Therefore, it may be judged whether to synthesize a plurality of images based on the light received at different parts of the pixel in one photographing. In addition, the photographing device 100 is different from the existing photographing device, and does not need the aperture function of a mechanical lens. For example, in one photographing, a plurality of images with different aperture values may be obtained at the same time through electronic processing. Moreover, for example, after photographing, the photographing device 100 may perform the image processing using the plurality of acquired images with different aperture values, and may also electronically change at least one of the depth of field (for example, change to increase or decrease the depth of field) and the incident light amount.

Fig. 6 is a flow chart illustrating an example of an image generation processing according to the embodiment of the present disclosure. As shown in Fig. 6, the photographing device 100 receives the primary signal PS at the central sub-pixel 2a and the secondary signal SS at the peripheral sub-pixel 2b shown in Figs. 1 and 3 (step S1). The photographing device 100 generates the primary image (the first image) based on the primary signal PS (step S2). The photographing device 100 judges whether the primary image satisfies the specified condition (step S3). If the specified condition related to the primary image is satisfied (in the case of "No"), step S4 is executed. The photographing device 100 takes the generated primary image as the final image (step S4).

On the other hand, if the primary image does not meet the specified condition (in the case of "Yes" at step S3), step S5 is executed. The photographing device 100 generates the secondary image (the second image) based on the secondary signal SS (step S5). The photographing device 100 generates the final image (a third image) based on the generated primary image and secondary image (step S6).

In addition, the order of the steps of the image generation process of the embodiment is not limited to the above, and may be changed appropriately. For example, the generation of the secondary image based on the secondary signal SS (step S5) may be performed together with the generation of the primary image based on the primary signal PS at step S2. In this case, in the case of "Yes" at step S3, step S5 is omitted and step S6 is executed. On the other hand, in the case of "No" at step S3, the secondary image based on the generated secondary signal SS is not used, and only the primary image is used as the final image.

Fig. 7 is a diagram illustrating an example of a processing of electronically adjusting the background bokeh according to the embodiment of the present disclosure. The analysis unit 32 shown in Fig. 5 analyzes, for example, the primary image based on the primary signal PS and the secondary image based on the primary signal PS and the secondary signal SS (the secondary images based on the primary image and the secondary image). The analysis unit 32 performs a spatial frequency analysis on the primary image and the secondary image. For example, the analysis unit 32 calculates a correlation between the primary image and the secondary image, and specifies a part with a high correlation (for example, an in-focus part) or a part with a small correlation (for example, an out-of-focus part).

The analysis unit 32 generates an out-of-focus image based on the analysis result of the primary image and the secondary image by the analysis unit 32. Moreover, based on the out-of-focus image generated by the analysis unit 32, the filtering processing unit 34 performs, for example, the low-pass filtering processing on the part with the small correlation of the secondary image. In this way, the photographing device 100 may generate the final image with a small depth of filed by synthesizing the primary image and the secondary image.

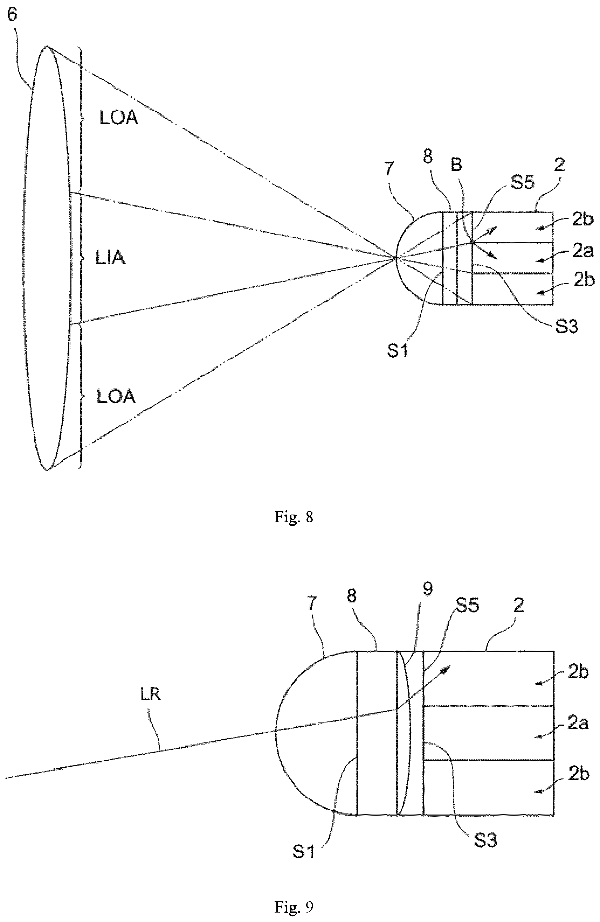

Fig. 8 is a diagram illustrating an example of a light traveling situation due to the fluctuation of the light according to the embodiment of the present disclosure. For example, in the case where the sizes of the central sub-pixel 2a and the peripheral sub-pixel 2b are small, the separation ability of the light at the central sub-pixel 2a and the peripheral sub-pixel 2b may decrease due to the fluctuation of the light, and the light-gathering efficiency in the sub-pixels may decrease.

Specifically, as shown in Fig. 8, for example, all the light incident on a boundary B between the central sub-pixel 2a and the peripheral sub-pixel 2b usually does not converge on one of the central sub-pixel 2a or the peripheral sub-pixel 2b. Actually, divided by the fluctuation of the light, it converges to both the central sub-pixel 2a and the peripheral sub-pixel 2b.

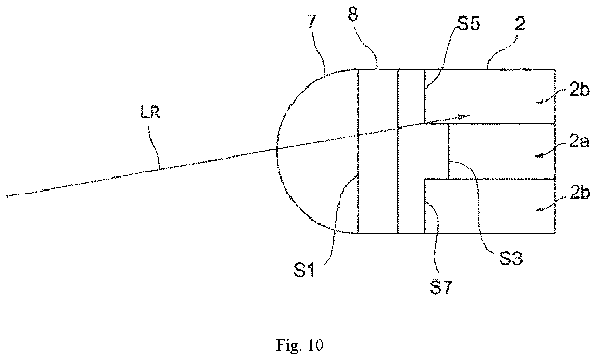

Therefore, in this embodiment, as shown in Figs. 9 and 10, the photographing device 100 is configured so that an effective optical path length (a first optical path length) related to a light LR from a light exit surface S1 of the plurality of microlenses 7 to a light photoelectric conversion surface S3 (a first incident surface) of the central sub-pixel 2a is different from an effective optical path length (a second optical path length) related to the light LR from the exit surface S1 to a light photoelectric conversion surface S5 (a second incident surface) of the peripheral sub-pixel 2b. According to this configuration, the light separation ability at the boundary between the central sub-pixel 2a and the peripheral sub-pixel 2b may be improved. Therefore, the light-gathering efficiency in the sub-pixels may be improved.

As shown in Fig. 9, in the photographing device 100, a convex lens 9 is arranged between the exit surface S1 and the light photoelectric conversion surface S3 of the central sub-pixel 2a as well as the light photoelectric conversion surface S5 of the peripheral sub-pixel 2b (for example, a surface of the color filter 8 on a side where the pixel 2 is). According to the properties (e.g., a shape and a refractive index) of the convex lens 9, the traveling situation (e.g., a traveling direction) of the light in the convex lens 9 may be adjusted. Therefore, by using the convex lens 9, the effective optical path length from the exit surface S1 to the photoelectric conversion surface S3 may be different from the effective optical path length from the exit surface S1 to the photoelectric conversion surface S5. The properties of the convex lens 9 are arbitrary, as long as the traveling situation of the light may be adjusted to the extent that the light separation ability at the boundary between the central sub-pixel 2a and the peripheral sub-pixel 2b may be improved.

Further, the arrangement position of the convex lens 9 is arbitrary, as long as it is between the exit surface S1 and the light photoelectric conversion surface S3 of the central sub-pixel 2a as well as the light photoelectric conversion surface S5 of the peripheral sub-pixel 2b. The arrangement position of the convex lens 9 may be arranged on the exit surface S1 of the microlens 7 or between the color filter 8 and the pixel 2.

As shown in Fig. 10, in the photographing device 100, the pixel 2 (the central sub-pixel 2a and the peripheral sub-pixel 2b) is configured in such a manner that a first distance from the exit surface S1 to the photoelectric conversion surface S3 is different from a second distance from the exit surface S1 to the photoelectric conversion surfaces S5, S7. For example, in the photographing device 100, the pixel 2 (the central sub-pixel 2a and the peripheral sub-pixel 2b) is configured in such a manner that the photoelectric conversion surface S3 and the photoelectric conversion surfaces S5, S7 have different heights.

More specifically, the pixel 2 is configured in such a manner that the photoelectric conversion surface S3 is closer to the exit surface S1 of the microlens 7 than the photoelectric conversion surfaces S5, S7. In addition, the photoelectric conversion surface S5 and the photoelectric conversion surface S7 may have the same height or different heights.

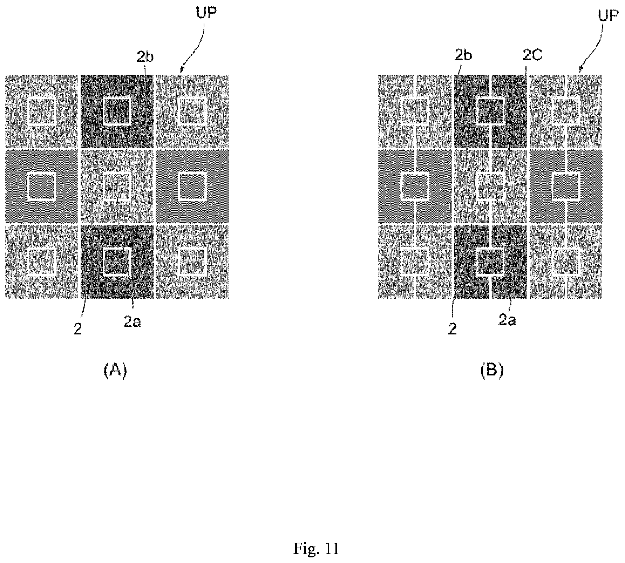

Fig. 11 is a diagram illustrating an example of a configuration of a sub-pixel according to the embodiment of the present disclosure. For example, the plurality of pixels 2 in a unit pixel (UP) in this embodiment are composed of sub-pixels corresponding to respective colors (for example, red, blue and green). The configuration of the sub-pixel is arbitrary, but for example, as shown in (A) of Fig. 11, the plurality of pixels 2 each have the central sub-pixel 2a and the peripheral sub-pixel 2b.

As shown in (B) of Fig. 11, the plurality of pixels 2 each may have the central sub-pixel 2a, the peripheral sub-pixel 2b, and a peripheral sub-pixel 2c. According to this configuration, the light passing through the central region LIA of the primary lens 6 shown in Fig. 1 may converge at the central sub-pixel 2a, and also, out-of-focus information may be detected at the left peripheral sub-pixel 2b and the right peripheral sub-pixel 2c.

In addition, in each of the plurality of pixels 2, the peripheral sub-pixel may include three or more peripheral sub-pixels. In addition, each of the plurality of pixels 2 may also include a plurality of central sub-pixels in addition to one or more peripheral sub-pixels.

In addition, the above embodiments are used to make the understanding of the present invention easy, and are not limited to the explanation of the present invention. The present invention may be changed/improved without departing from its themes, and the present invention also includes its equivalents. In addition, various disclosures of the present invention may be made by an appropriate combination of a plurality of constituent elements disclosed in the above embodiments. For example, several constituent elements may be deleted from all the constituent elements shown in the embodiments. Furthermore, the constituent elements may be appropriately combined in different embodiments.

The photographing device 100 of the present disclosure may be applied to digital cameras and terminal devices such as smart phones, tablet terminals and laptop personal computers with camera functions.

### Description of reference numerals:

1-control circuit, 2-pixel, 3-signal line, 4-readout circuit, 5-digital signal processing unit (DSP), 6-primary lens, 7-microlens, 8-color filter, 10-image sensor, 20-optical system, 30-control unit, 32-analysis unit, 34-filtering processing unit, 36-image generation unit, 100-photographing device, S-object to be photographed.

## Claims

1. A photographing device, comprising:
a plurality of microlenses;
a photographing element having a plurality of pixels arranged on each of the plurality of microlenses and configured to receive light from the plurality of microlenses; and
an image generation unit configured to generate an image based on the light received at the plurality of pixels,
wherein the plurality of pixels each have a first part comprising a central part and a second part surrounding the central part,
the image generation unit is configured to judge whether to synthesize a first image based on the light received at the first part with a second image based on the light received at the second part based on a specified condition.

2. The photographing device according to claim 1, wherein,
the image generation unit is configured to synthesize the first image with the second image by using information related to the second image based on the specified condition.

3. The photographing device according to claim 1, wherein,
the specified condition comprises a condition regarding at least one of a depth of field and a sensitivity to light related to the first image.

4. The photographing device according to claim 1, wherein,
a first optical path length from a light exit surface of the plurality of microlenses to a first light incident surface of the first part is different from a second optical path length from the exit surface to a second light incident surface of the second part.

5. The photographing device according to claim 4, wherein,
a convex lens is arranged between the exit surface and the first incident surface as well as the second incident surface.

6. The photographing device according to claim 4, wherein,
a first distance from the exit surface to the first incident surface is different from a second distance from the exit surface to the second incident surface.

7. A control method, executed by a processor comprised in a photographing device, and comprising:
a generation step, wherein an image is generated based on light received by a plurality of pixels arranged on each of a plurality of microlenses comprised in the photographing device and from the plurality of microlenses,
the plurality of pixels each have a first part comprising a central part and a second part surrounding the central part,
the generation step is judging whether to synthesize a first image based on the light received at the first part with a second image based on the light received at the second part based on a specified condition.

8. A terminal, comprising a photographing device according to any one of claims 1 to 6.
